# EUROPEAN PATENT SPECIFICATION

(11) **EP 4 471 865 B1**
(45) Date of publication and mention of the grant of the patent: **04.11.2026**
(21) Application number: 24177347.2
(22) Date of filing: 22.05.2024
(51) Int. Cl.: H10D 30/01, H10D 30/66, H10D 62/10, H10D 64/01, H10D 64/00, H10D 64/27, H10P 30/20

(54) **GATE CONTACT STRUCTURE FOR A TRENCH POWER MOSFET WITH A SPLIT GATE CONFIGURATION**
GATE-KONTAKTSTRUKTUR FÜR EINEN GRABEN-LEISTUNGS-MOSFET MIT GETEILTER GATE-KONFIGURATION
STRUCTURE DE CONTACT DE GRILLE POUR UN MOSFET DE PUISSANCE À TRANCHÉE AVEC UNE CONFIGURATION DE GRILLE DIVISÉE

(30) Priority: 31.05.2023 US 202363469927 P; 01.04.2024 US 202418623604
(43) Date of publication of application: 04.12.2024
(73) Proprietor: STMicroelectronics International N.V., 1228 Plan-les-Ouates, Geneva (CH)
(72) Inventor: CASTORINA, Maurizio Gabriele, 328190 Singapore (SG); NGWAN, Voon Cheng, 732686 Singapore (SG)
(74) Representative: Cabinet Beaumont

(56) References cited:
- DE-A1- 102014 109 665
- US-A1- 2020 251 565
- US-A1- 2021 091 188
- US-A1- 2022 052 190
- US-A1- 2022 320 332

## Description

### CROSS REFERENCE TO RELATED APPLICATIONS

### TECHNICAL FIELD

Embodiments herein generally relate to metal oxide semiconductor field effect transistor (MOSFET) devices and, in particular, to a gate contact structure for a trench-type power MOSFET having a split gate configuration including a pair of polysilicon gate lobes laterally separated by a region of oxidized polysilicon, herein also referred to as polyoxide, and electrically coupled by a polysilicon gate bridge Such transistors are generally known from DE 10 2014 109665 A1 and US 2022/320332.

### BACKGROUND

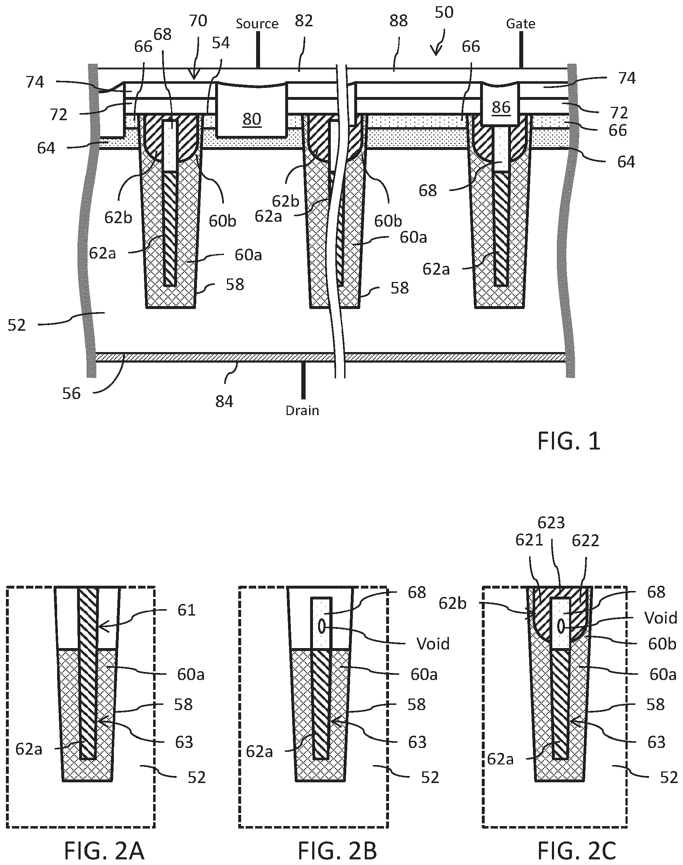

Figure 1 shows a cross-section of a power metal oxide semiconductor field effect transistor (MOSFET) device 50. In this example, the MOSFET is an n-channel (nMOS) type device formed in and on a semiconductor substrate 52 doped with n-type dopant which provides the drain of the transistor 50. The substrate 52 has a front side 54 and a back side 56. A plurality of trenches 58 extend depthwise into the substrate 52 from the front side 54. The trenches 58 extend lengthwise (i.e., longitudinally) parallel to each other in a direction perpendicular to the cross-section (i.e., into and out the page of the illustration) and form strips (this type of transistor device commonly referred to in the art as a strip-FET type transistor).

A region 64 doped with a p-type dopant is buried in the substrate 52 at a depth offset from (i.e., below) the front side 54 and positioned extending parallel to the front side 54 on opposite sides of each trench 58. The doped region 64 forms the body (channel) region of the transistor, with the trench 58 passing completely through the doped body region 64 and into the substrate 52 below the doped body region 64. A region 66 doped with an n-type dopant is provided at the front side 54 of the substrate 52 and positioned extending parallel to the front side 54 on opposite sides of each trench 58 and in contact with the top of the doped body region 64. The doped region 66 forms the source of the transistor, with the trench 58 passing completely through the doped source region 66 and further extending, as noted above, completely through the doped body region 64 into the substrate 52 below the doped body region 64.

The side walls and bottom of each trench 58 are lined with a first (thick) insulating layer 60a. For example, the insulating layer 60a may comprise a thick oxide layer. The trench 58 is then filled by a first polysilicon material 62a, with the insulating layer 60a insulating the first polysilicon material 62a from the substrate 52. The polysilicon material 62a is a heavily n-type doped polysilicon material (for example, Phosphorus doped with a doping concentration of 5 x 10²⁰ at/cm³). During the process for fabricating the transistor 50, an upper portion of the insulating layer 60a (which would be adjacent to both the doped body region 64 and doped region 66) is removed from the trench 58 to expose a corresponding upper portion 61 of the polysilicon material 62a (see, Figure 2A). This exposed upper portion 61 of the polysilicon material 62a is then converted (for example, using a thermal oxidation process) to form a polyoxide region 68 that is vertically aligned in the trench 58 with the remaining (lower) portion 63 of the polysilicon material 62a (See, Figure 2B). This remaining lower portion 63 of the polysilicon material 62a forms a field plate electrode of the transistor 50 (referred to also as the polysource region because it is typically electrically shorted to the source region 66 - this electrical connection is not explicitly shown in the figures). The side walls and bottom of the upper portion of each trench 58 are then lined with a second (thin) insulating layer 60b (see, Figure 2C). For example, the insulating layer 60b may comprise a thermally grown thin oxide layer. The oxide lined upper portion of each trench 58 is then filled by a second polysilicon material 62b, with the insulating layer 60b insulating the second polysilicon material 62b from the substrate 52 (including regions 64 and 66). The second polysilicon material 62b forms the gate (referred to also as a polygate region) of the transistor 50 and includes a first (for example, left) gate lobe 621 and second (for example, right) gate lobe 622 which extend on opposite sides of the polyoxide region 68. The first and second gate lobes are electrically coupled by a gate bridge portion 623 extending over the polyoxide region 68. The insulating layer 60b forms the gate oxide layer.

A stack 70 of layers is formed above the upper surface of the substrate. The stack 70 includes an undoped oxide (for example, tetraethyl orthosilicate (TEOS)) layer 72 and a glass (for example, borophosphosilicate glass (BPSG)) layer 74. The stack 70 may further include additional insulating and/or barrier layers if needed. For example, a thin silicon nitride layer (not explicitly shown) may be provided between TEOS layer 72 and the upper surface 54 of the substrate 52.

With reference to the left side of Figure 1, a source metal contact 80 extends through the layers of the stack 70, positioned between the locations of adjacent trenches 58, to make electrical contact with the doped source region 66. Each source metal contact 80 extends depthwise into the substrate to pass through the doped source region 66 and partially into the doped body region 64 (thus providing a body contact for the transistor 50 that is tied to the source). A source metal layer 82 extends over both the stack 70 and the source metal contacts 80 to provide an electrical connection to and between all source metal contacts 80. The layers of the stack 70 insulate both the source metal layer 82 and the source metal contacts 80 from the polygate (second polysilicon region 62b).

With reference now to the right side of Figure 1, a gate metal contact 86 extends through the layers of the stack 70, positioned in alignment with the locations of the trenches 58, to make electrical contact with the second polysilicon region 62b in each trench 58 (for example, by making contact at the location of the bridge portion 623). It will be noted that the gate metal contact 86 preferably extends depthwise at least partially into the filled trench, for example extending into at least the upper part of the bridge portion 623 (and perhaps extending completely through the bridge portion). A gate metal layer 88 extends over both the stack 70 and the gate metal contacts 86 to provide an electrical connection to and between all gate metal contacts 86. The layers of the stack 70 insulate both the gate metal layer 88 and the gate metal contacts 86 from the source metal contacts and source regions. The polyoxide region 68 insulates the polysource region 62a from the gate metal contact 86.

The cross-sections on the left and right sides of Figure 1 are in practice actually longitudinally offset from each other in the direction perpendicular to the cross-section (i.e., into and out the page of the illustration). In this configuration, an insulating separation is provided between the source metal layer 82 and the gate metal layer 88.

A drain metal layer 84 extends over the back side 56 of the substrate 52 to provide a metal connection to the drain.

The transistor 50 could instead be a pMOS type transistor where the substrate 52 and doped source region 56 are both p-type doped and the body region 54 is n-type doped.

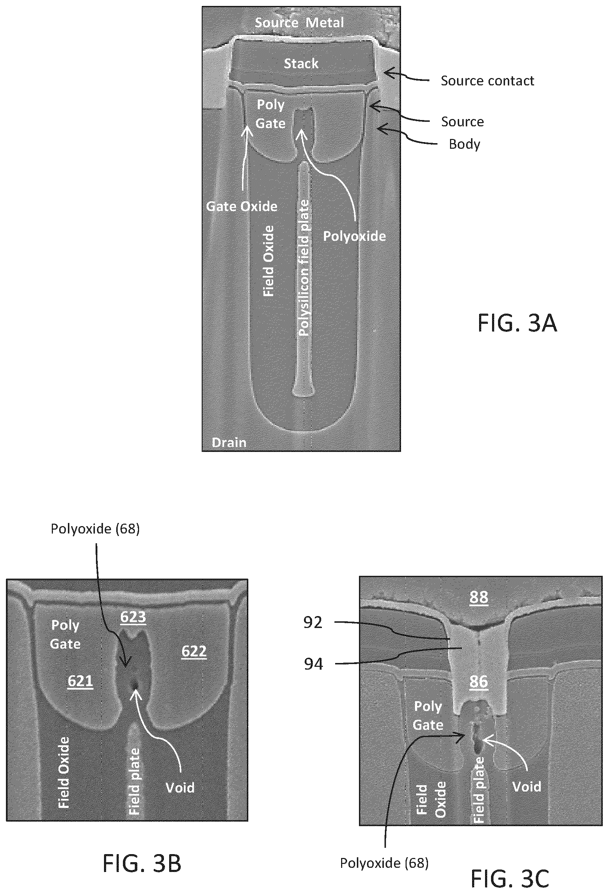

Figure 3A shows a scanning electron micrograph (SEM) cross-sectional image of a single cell of the transistor 50 corresponding to the left side of Figure 1.

During the formation of the polyoxide region 68 (see, Figure 2B), there is a lateral and vertical material expansion as the polysilicon material 62a is converted into the polyoxide region 68. This expansion induces a tension which can produce a void (or seam or cavity) within the polyoxide material. The existence and location of such voids in the polyoxide region 68 is unpredictable. Figure 3B shows a scanning electron micrograph (SEM) cross-sectional image focusing on the region where the trench 58 is located to illustrate by example the existence of such a void (see, also, Figure 2B). Depending on the width of the trench 58 and the size of the polygate formed by lobes 621, 622 and bridge 623, the void in the polyoxide region 68 may extend close to the inner surface of the polygate (see, Figure 3C) and this can have an impact on the formation of the gate contact 86 and, as will be discussed below, increase the risk of current leakage and/or the formation of a short to the source through the polysource region 62a.

The process for formation of the gate contact 86 utilizes a mask with a mask opening aligned with the center of the trench 58. An etch performed using this mask produces a gate opening extending through the stack 70 and at least partially into, if not completely through, the bridge 623 of the second polysilicon region 62b which forms the polygate. That etch may include multiple, discrete, etch steps including a first etch to remove the layers of the stack 70 and a second etch to extend into the bridge 623 for a desired depth. The size of the mask opening, and the corresponding gate opening, is typically designed to be about, and more preferably less than, one-half the size (width) of the trench 58 and is generally speaking preferably aligned with the center of the trench. A barrier layer 92 formed of a Titanium-Titanium Nitride (Ti-TiN) material is then conformally deposited into the etched gate opening, and the gate opening is then filled with a plug 94 made of a conductive material (such as, for example, Tungsten) to form the gate contact 86. Figure 3C shows a scanning electron micrograph (SEM) cross-sectional image focusing on the gate contact 86 and illustrating that the gate opening has passed completely through the gate bridge 623 to reach the polyoxide region 68.

Control over the depth of the second etch is difficult to ensure, and the possible existence and location of the void in the polyoxide region 68 is difficult to predict. There accordingly exists a non-negligible risk that the second etch will pass completely through the bridge 623, with the gate opening extending partially into the polyoxide region 68 to reach the void. Additionally, the etched opening may extend at least partially around the polyoxide region 68. The conformally deposited Ti-TiN barrier layer may not adequately cover this location due to the difficult topology presented by the possible void in combination with the gate opening, and thus the conductive material for the plug that is deposited in the gate opening may present a leakage path or short-circuit between the polygate and the polysource provided by the field plate (which, as noted above, is electrically connected to the source region).

United States Patent Publication No. 2022/0320332 presents solutions to address the foregoing problem in power MOSFET devices and provide for a better electrical contact to a split gate configuration including a pair of polysilicon gate lobes laterally separated by a polyoxide region and electrically coupled by a polysilicon gate bridge.

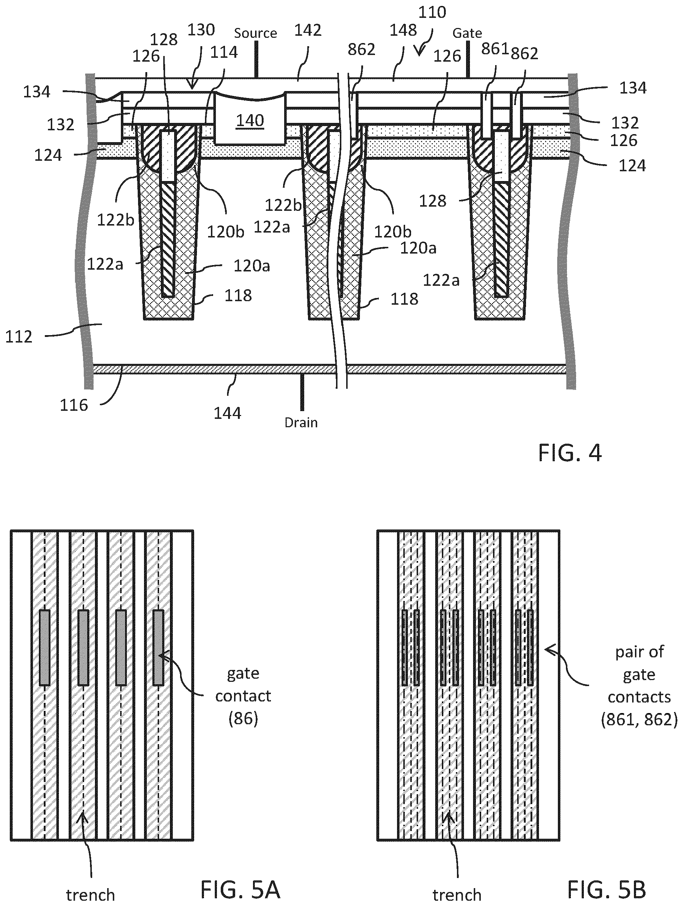

Reference is now made to Figure 4 which shows a lateral cross-section of a power metal oxide semiconductor field effect transistor (MOSFET) device 110 in accordance with the teaching of United States Patent Publication No. 2022/0320332. In this example, the MOSFET is an n-channel (nMOS) type device formed in and on a semiconductor substrate 112 doped with n-type dopant which provides the drain of the transistor 110. The substrate 112 has a front side 114 and a back side 116. A plurality of trenches 118 extend depthwise into the substrate 112 from the front side 114. The trenches 118 longitudinally extend with a desired length parallel to each other in a direction perpendicular to the cross-section (i.e., into and out of the page of the illustration) and form strips (this type of transistor device commonly referred to in the art as a strip-FET type transistor).

A region 124 doped with a p-type dopant is buried in the substrate 112 at a depth offset from (i.e., below) the front side 114 and positioned laterally extending parallel to the front side 114 on opposite sides of each trench 118. The doped region 124 forms the body (channel) region of the transistor, with the trench 118 passing completely through the doped body region 124 and into the substrate 112 below the doped body region 124. A surface implant region 126 doped with an n-type dopant is provided at the front side 114 of the substrate 112 and positioned extending parallel to the front side 114 on opposite sides of each trench 118 and in contact with the top of the doped body region 124. The doped region 126 forms the source of the transistor, with the trench 118 passing completely through the doped source region 126 and further extending, as noted above, completely through the doped body region 124 into the substrate 112 below the doped body region 124.

The side walls and bottom of each trench 118 are lined with a first insulating layer 120a. For example, the insulating layer 120a may comprise a thick oxide layer. The trench 118 is then filled by a first polysilicon material 122a, with the insulating layer 120a insulating the first polysilicon material 122a from the substrate 112. The first polysilicon material 122a is a heavily n-type doped polysilicon material (for example, Phosphorus doped with a doping concentration of 5 x 10²⁰ at/cm³). With additional reference to Figures 2A-2C, during the process for fabricating the transistor 110, an upper portion of the insulating layer 120a (which would be adjacent to both the doped body region 124 and doped region 126) is removed from the trench 118 to expose a corresponding upper portion of the first polysilicon material 122a. This exposed upper portion of the first polysilicon material 122a is then converted (for example, using a thermal oxidation process) to form a polyoxide region 128 that is vertically aligned in the trench 118 with the remaining (lower) portion of the first polysilicon material 122a. This remaining lower portion of the first polysilicon material 122a forms a field plate electrode of the transistor 110 (referred to also as the polysource region because it is typically electrically shorted to the source region 126 - this electrical connection is not explicitly shown in the figures). The side walls and bottom of the upper portion of each trench 118 are then lined with a second insulating layer 120b. For example, the insulating layer 120b may comprise a thermally grown oxide layer. The upper portion of each trench 118 is then filled by a second polysilicon material 122b, with the insulating layer 120b insulating the second polysilicon material 122b from the substrate 112 (including regions 124 and 126). The second polysilicon material 122b forms the gate (referred to as a polygate region) of the transistor 110 and includes a first (for example, left) gate lobe 621 and second (for example, right) gate lobe 622 which longitudinally extend in the trench on opposite sides of the polyoxide region 128. The first and second gate lobes are connected by a gate bridge portion 623 laterally extending over the polyoxide region 128. The insulating layer 120b forms the gate oxide layer.

A stack 130 of layers is formed above the upper surface of the substrate. The stack 130 includes an undoped oxide (for example, tetraethyl orthosilicate (TEOS)) layer 132 and a glass (for example, borophosphosilicate glass (BPSG)) layer 134. The stack 130 may further include additional insulating and/or barrier layers if needed. For example, a thin silicon nitride layer (not explicitly shown) may be provided between TEOS layer 132 and the upper surface 114 of the substrate 112.

With reference to the left side of Figure 4, a source metal contact 140 extends through the layers of the stack 130, positioned between the locations of adjacent trenches 118, to make electrical contact with the doped source region 126. Each source metal contact 140 extends depthwise into the substrate to pass through the doped source region 136 and partially into the doped body region 134 (thus providing a body contact for the transistor 110 that is tied to the source). A source metal layer 142 extends over both the stack 130 and the source metal contacts 140 to provide an electrical connection to and between all source metal contacts 140. The layers of the stack 130 insulate both the source metal layer 142 and the source metal contacts 140 from the polygate (second polysilicon region 122b).

With reference now to the right side of Figure 4, the gate metal contact for each polygate is formed by a pair of contacts 861 and 862, where each contact 861, 862 extends through the layers of the stack 130, positioned in vertical alignment with the location of a corresponding lobe 621, 622 (respectively) of the polygate, to make electrical contact with the respective lobe of the second polysilicon region 122b in each trench 118. In a preferred implementation, each gate metal contact 861, 862 extends depthwise at least partially into an upper portion of the corresponding lobe 621, 622 on either side of the bridge 623. A gate metal layer 148 extends over both the stack 130 and the gate metal contacts 861, 862 to provide an electrical connection to and between all gate metal contacts 861, 862. The layers of the stack 130 insulate both the gate metal layer 148 and the gate metal contacts 861, 862 from the source metal contacts and source regions. It will be noted that a portion of the stack serves to laterally insulate the contact 861 from the contact 862 at the level of layers within the stack.

The cross-sections on the left and right sides of Figure 4 are, in practice, actually longitudinally offset from each other in the direction perpendicular to the cross-section (i.e., into and out of the page of the illustration). In this configuration, an insulating separation is provided between the source metal layer 142 and the gate metal layer 148.

A drain metal layer 144 extends over the back side 116 of the substrate 112 to provide a metal connection to the drain.

The transistor 110 could instead be a pMOS type transistor where the substrate 112 and doped source region 126 are both p-type doped and the body region 124 is n-type doped.

Figures 5A and 5B are plan views (i.e., looking downward towards the front surface of the substrate) comparing layouts for the transistors 50 and 110 with a specific focus showing the relative locations of the contacts 86 and the pair of contacts 861 and 862. The dotted line indicates the center line of each longitudinally extending trench, and the dash-dot line indicates the general location of the longitudinal center of each lobe of the polygate. Figure 5A generally corresponds to the implementation shown on the right side of Figure 1, while Figure 5B generally corresponds to the implementation shown on the right side of Figure 4. Although only one pair of contacts 861 and 862 per trench is shown in Figure 5B, it will be understood that this is by example only and that more than one pair per trench may be used if desired.

The structure of the gate contact shown in Figure 4 which utilizes a pair of side-by-side arranged contacts 861 and 862 addresses the concerns with problems that may arise in connection with the polyoxide region 148 possibly including a void. The combined size of the pair of contacts 861 and 862 is, preferably, substantially equal to the size of the gate contact 86 shown in Figure 1, and thus will provide substantially identical performance in terms of gate resistance. Splitting of each gate contact into two parts (contacts 861 and 862) and vertically aligning each part with a corresponding lobe 621, 622 of the polygate avoids making contact with the polygate in the center portion of the trench (i.e., at the location of the gate bridge region) and thus minimizes the risk that the etch used to form the contact openings will reach the void location.

In Figure 4 each contact 861, 862 may have a length dimension (in the longitudinal direction) of between 0.1µm and 10µm and a width dimension (perpendicular to the length dimension in the lateral direction) of between 0.1µm and 1µm.

It will be noted that in the implementation shown in Figure 4, with a lateral side-by-side arrangement of the pair of contacts 861, 862 the cross-section at a given location longitudinally along the length of the trench passes through both of the contacts 861, 862. The fabrication of a device having such an implementation requires that the gate mask include a very thin resist portion aligned with the spacing between the adjacent contacts at that given location. It is possible that this very thin resist portion could lift off during fabrication processing and adversely affect the accuracy of the etching operation to form each pair of gate contact openings. For example, malformed openings for each of the gate contacts could occur, or a merger of the two separate openings for the side-by-side pair of contacts into one large opening could occur. A solution to this concern is to instead design the gate mask so that the individual mask openings for producing the contacts 861, 862 are longitudinally offset from each other in the direction perpendicular to the cross-section (i.e., into and out of the page of the illustration).

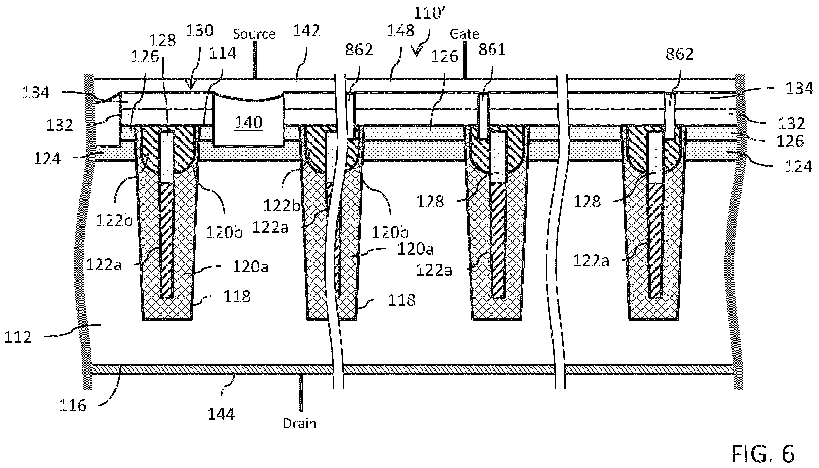

A transistor 110' structure resulting from such an arrangement of the mask openings is shown in Figure 6. Like references in Figure 6 refer to like or similar parts as shown in Figure 4. The left side of Figure 6 corresponds to the left side of Figure 4. The middle and right portions of Figure 6 illustrate the longitudinal offsetting of the gate contacts 861 and 862 for a given trench which result from a corresponding longitudinal offsetting of the mask openings. In particular, the middle portion of Figure 6 shows the cross section at locations where the mask openings for forming the first gate contacts 861 have been utilized so as to make electrical contact to the corresponding first (left) lobe 621 of the polygate. The right portion of Figure 6 shows the cross section at locations where the mask openings for forming the second gate contacts 862 have been utilized so as to make electrical contact to the corresponding second (right) lobe 622 of the polygate. Notwithstanding the longitudinal offset of the individual gate openings, it will be noted that each gate contact to a polygate within the trench is still formed by a pair of contacts 861 and 862.

**In** Figure 6 each contact 861, 862 may have a length dimension (in the longitudinal direction) of between 0.1µm and 10µm and a width dimension (perpendicular to the length dimension in the lateral direction) of between 0.1µm and 1µm. It will be noted that with the longitudinal offsetting of the contacts 861, 862 in Figure 6, each individual contact may be fabricated to have a wider width than the corresponding contact for the Figure 4 embodiment where the side-by-side arrangement may impose a constraint on contact width.

Figure 7A shows a scanning electron micrograph (SEM) cross-sectional image of a single cell of the transistor 110' corresponding to the middle portion of Figure 6 and focusing on the gate contact 861 for lobe 621 of the polygate.

Figure 7B shows a scanning electron micrograph (SEM) cross-sectional image of a single cell of the transistor 110' corresponding to the right side of Figure 6 and focusing on the gate contact 862 for lobe 622 of the polygate.

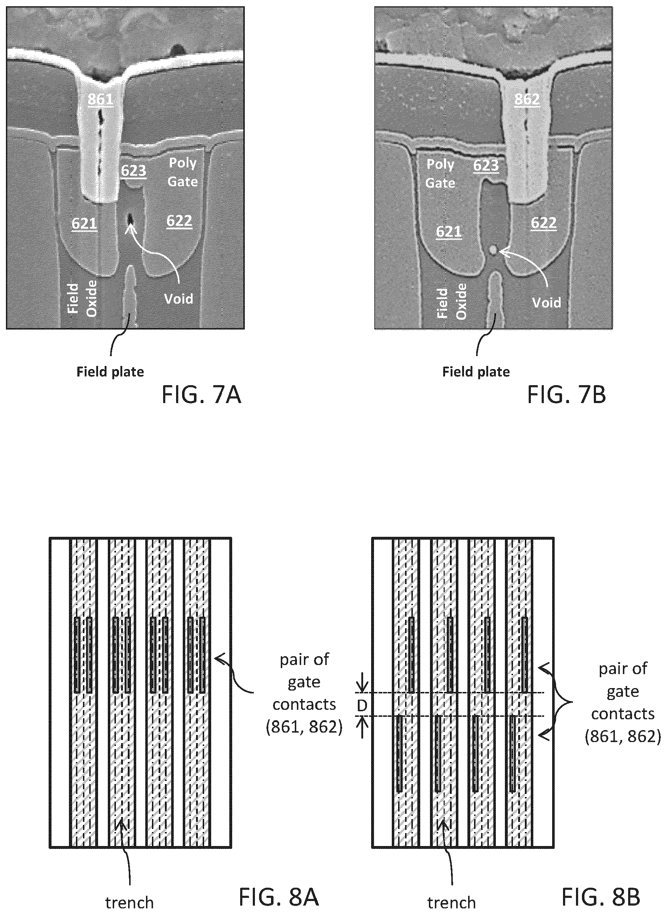

Figures 8A and 8B are plan views (i.e., looking downward towards the front surface of the substrate) comparing layouts for the transistors 110 and 110' with a specific focus showing the relative locations of the pair of contacts 861 and 862. The dotted line indicates the center line of each longitudinally extending trench, and the dash-dot line indicates the general location of the center of each lobe of the polygate. It will be noted that a longitudinal center of each contact 861, 862 is positioned between the longitudinal center of the corresponding gate lobe and the longitudinal center of the trench. This ensures that placement of the contact does not risk bridging across the gate oxide and shorting the polygate to the doped source region. Figure 8A generally corresponds to the implementation shown on the right side of Figure 4 (see, also Figure 5B), while Figure 8B generally corresponds to the implementation shown on the middle portion and right side of Figure 6. Although only one pair of contacts 861 and 862 per trench is shown in Figures 8A and 8B, it will be understood that this is by example only and that more than one pair per trench may be used if desired. From Figure 8B, it will be noted that the longitudinal offset of the pair of contacts 861 and 862 of a given trench is such that no cross section through that given trench in a plane perpendicular to the longitudinal direction of the given trench will pass through both the first gate contact and the second gate contact. This is effectuated by setting a sufficient longitudinal offset distance D between the end of the first gate contact and the adjacent end of the second gate contact in the longitudinal direction of the trench.

A concern with the solutions of Figures 4 and 6 is that it is difficult to implement in connection with transistors having a reduced pitch or transistors designed for lower voltage classes. The reason for this is that the reduced pitch, with a smaller trench opening, presents a smaller area at the gate lobe and it becomes increasingly difficult with scaling of the device to fit the off-centered contact 861, 862 into the gate lobe 621, 622, respectively.

There is accordingly a need in the art to provide for a further improved gate contact and method of making same for use in connection with a trench-type power MOSFET having a split gate configuration including a pair of polysilicon gate lobes laterally separated by a polyoxide region and electrically coupled by a polysilicon gate bridge.

### SUMMARY

The present invention concerns a method for manufacturing a trench-gate field-effect transistor according to claim 1, as well as a trench-gate field-effect transistor according to claim 6. Preferred embodiments are defined by the dependent claims.

The invention is set out in the appended set of claims.

### BRIEF DESCRIPTION OF THE DRAWINGS

For a better understanding of the embodiments, reference will now be made by way of example only to the accompanying figures in which:
Figure 1 is a cross-section of a prior art power metal oxide semiconductor field effect transistor (MOSFET) device;
Figures 2A-2C show process steps in the manufacture of the power MOSFET device of Figure 1;
Figures 3A-3C are scanning electron micrograph images of a cross-section of the power MOSFET device of Figure 1;
Figure 4 is a cross-section of a prior art power MOSFET device;
Figures 5A and 5B illustrate gate contact layout configurations for the power MOSFET devices of Figures 1 and 4, respectively;
Figure 6 is a cross-section of a further prior art power MOSFET device;
Figures 7A-7B are scanning electron micrograph images of a cross-section of the power MOSFET device of Figure 6;
Figures 8A and 8B illustrate gate contact layout configurations for the power MOSFET devices of Figures 4 and 6, respectively;

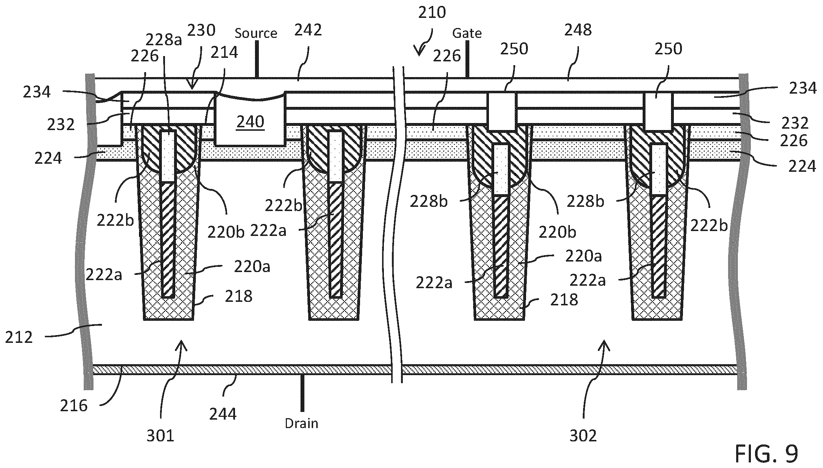

Figure 9 is a cross-section of a power MOSFET device; according to the present invention

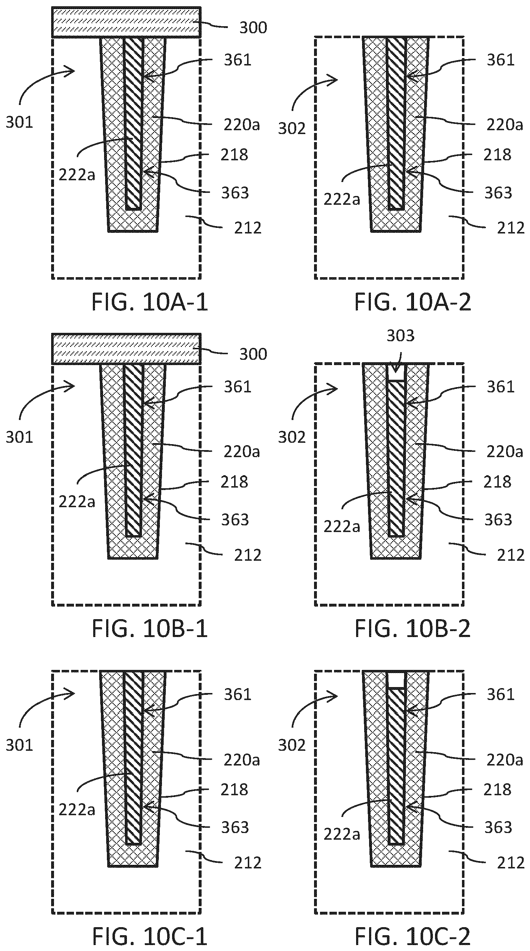

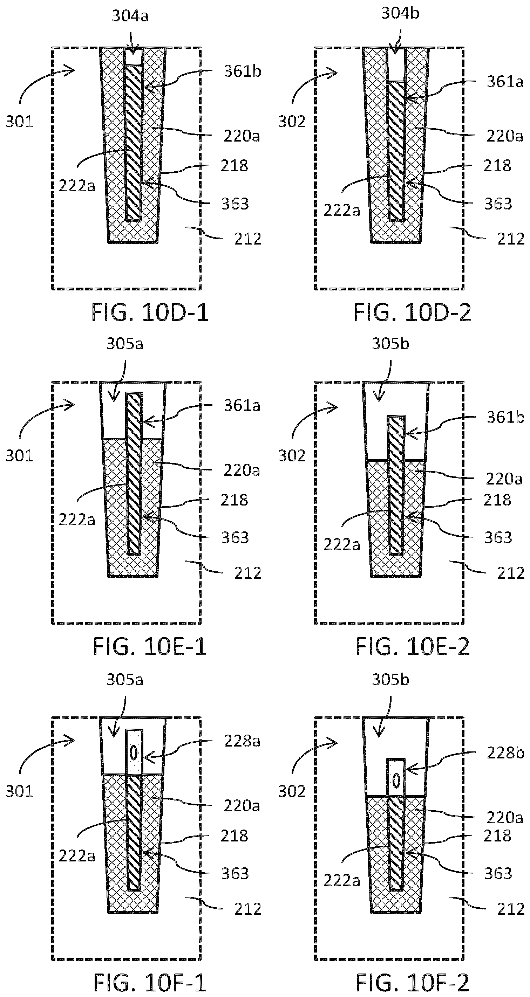

Figures 10A-1 to 10G-2 show process steps in the manufacture of the power MOSFET device of Figure 9, according to the present invention; and

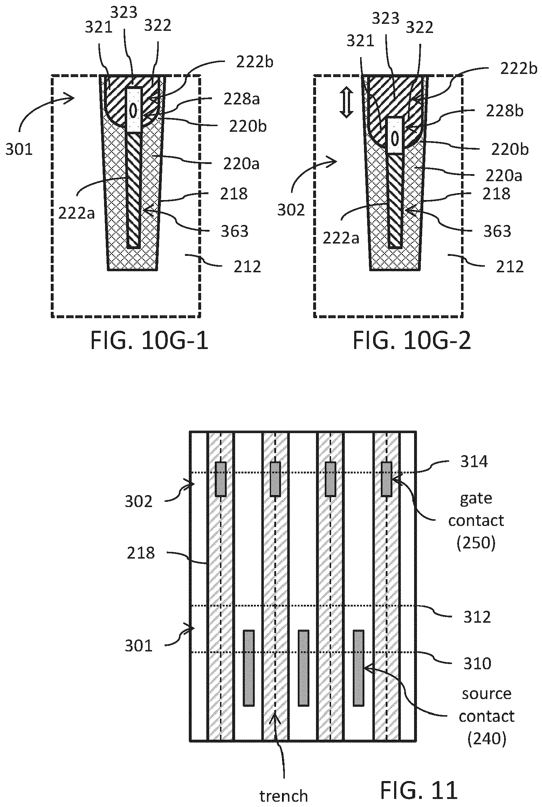

Figure 11 illustrates gate and source contact layout for the power MOSFET device of the present invention shown in Figure 9.

### DETAILED DESCRIPTION

Reference is now made to Figure 9 which shows a lateral cross-section of a power metal oxide semiconductor field effect transistor (MOSFET) device 210. In this example, the MOSFET is an n-channel (nMOS) type device formed in and on a semiconductor substrate 212 doped with n-type dopant which provides the drain of the transistor 210. The substrate 212 has a front side 214 and a back side 216. A plurality of trenches 218 extend depthwise into the substrate 212 from the front side 214. The trenches 218 longitudinally extend with a desired length parallel to each other in a direction perpendicular to the cross-section (i.e., into and out of the page of the illustration) and form strips (this type of transistor device commonly referred to in the art as a strip-FET type transistor).

A region 224 doped with a p-type dopant is buried in the substrate 212 at a depth offset from (i.e., below) the front side 214 and positioned laterally extending parallel to the front side 214 on opposite sides of each trench 218. The doped region 224 forms the body (channel) region of the transistor, with the trench 218 passing completely through the doped body region 224 and into the substrate 212 below the doped body region 224. A surface implant region 226 doped with an n-type dopant is provided at the front side 214 of the substrate 212 and positioned extending parallel to the front side 214 on opposite sides of each trench 218 and in contact with the top of the doped body region 224. The doped region 226 forms the source of the transistor, with the trench 218 passing completely through the doped source region 226 and further extending, as noted above, completely through the doped body region 224 into the substrate 212 below the doped body region 224.

The side walls and bottom of each trench 218 are lined with a first insulating layer 220a. For example, the insulating layer 220a may comprise a thick oxide layer. The trench 218 is then filled by a first polysilicon material 222a, with the insulating layer 220a insulating the first polysilicon material 222a from the substrate 212. The first polysilicon material 222a is a heavily n-type doped polysilicon material (for example, Phosphorus doped with a doping concentration of 5 x 10²⁰ at/cm³). During the process for fabricating the transistor 210, regions 301 of the upper surface of the substrate 212 are covered by a mask 300 (Figure 10A-1). However, the mask includes an opening at regions 302 where transistor gate contacts are going to be formed (Figure 10A-2). A first selective recess of the upper portion 361 of the first polysilicon material 222a at regions 302 is then performed to produce opening 303 (see, Figures 10B-1 and 10B-2) by selectively removing a first portion of the first polysilicon material 222a at regions 302. This recess operation may, for example, be implemented using a dry polysilicon selective etch. The mask 300 is then removed (see, Figures 10C-1 and 10C-2). A second selective recess of the upper portion 361 of the first polysilicon material 222a at regions 301 and 302 is then performed to produce openings 304a and 304b (see, Figures 10D-1 and 10D-2), where opening 304b is an extension in depth of opening 303, by selectively removing a second portion of the first polysilicon material 222a at regions 301 and further selectively removing a third portion of the first polysilicon material 222a at regions 302. This recess operation may, for example, be implemented using a dry polysilicon selective etch. As a result of the selective recessing operations, the first polysilicon material 222a at regions 301 is recessed to a first level and the first polysilicon material 222a at regions 302 is recessed to a second level (greater in depth than the first level). An upper portion of the insulating layer 220a (which would be adjacent to both the doped body region 124 and doped region 126) is removed from the trench 218 to expose a corresponding upper portion 361a of the first polysilicon material 222a in region 301 and a corresponding upper portion 361b of the first polysilicon material 222a in region 302 (see, Figures 10E-1 and 10E-2). The removal of the upper portion of the insulating layer 220a may, for example, be accomplished using a wet buffered oxide etch (BOE) that is selective to remove the oxide material of the insulating layer 220a while leaving the first polysilicon material 222a and substrate 212 in place. It will be noted that because of the difference in depths of the openings 304a, 304b that result from the recess of the first polysilicon material 222a in regions 301 and 302, respectively, there will be a corresponding difference in depths of the openings 305a and 305b, respectively, in the regions 301 and 302 produced by the wet BOE (where opening 305a has a first depth and opening 305b has a second depth that is greater than the first depth). The exposed upper portions 361a, 361b of the first polysilicon material 222a are then converted (for example, using a thermal oxidation process) to form polyoxide regions 228a, 228b that are vertically aligned in the trench 218 with the remaining (lower) portions of the first polysilicon material 222a (see, Figures 10F-1 and 10F-2). For reasons previously noted herein, this thermal oxidation process can in some cases produce voids in polyoxide regions 228a, 228b. It will be noted that the upper surfaces of the polyoxide regions 228a, 228b are recessed to different levels in the first and second regions 301, 302, respectively. The remaining lower portions of the first polysilicon material 222a form field plate electrodes of the transistor 210 (referred to also as the polysource regions because they are typically electrically shorted to the source regions 226 - this electrical connection is not explicitly shown in the figures). The side walls and bottom of the upper portion of each trench 218 are then lined with a second insulating layer 220b. For example, the insulating layer 220b may comprise a thermally grown oxide layer. The upper portion of each trench 218 is then filled by a second polysilicon material 222b, with the insulating layer 220b insulating the second polysilicon material 222b from the substrate 212 (including regions 224 and 226). See, Figures 10G-1 and 10G-2. The second polysilicon material 222b forms the gate (referred to as a polygate region) of the transistor 210 and includes a first (for example, left) gate lobe 321 and second (for example, right) gate lobe 322 which longitudinally extend in the trench on opposite sides of the polyoxide regions 228a, 228b. The first and second gate lobes are connected by a gate bridge portion 323 laterally extending over the polyoxide regions 228a, 228b. It will be noted that the vertical thicknesses of the bridge portions 323 are different in the regions 301 and 302. Specifically, the bridge portion 323 in region 302 where the transistor gate contact is going to be formed is thicker than the bridge portion 323 in region 301. The reason for, and advantage of, this will be apparent from the discussion below concerning the subsequent provision of the gate contact. It will also be noted that the first and second gate lobes 321, 322, extend to different depths in depths in the first and second regions 301, 302, respectively (the depth being greater in region 302 than in region 301). The insulating layer 220b forms the gate oxide layer.

A stack 230 of layers is formed above the upper surface of the substrate. The stack 230 includes an undoped oxide (for example, tetraethyl orthosilicate (TEOS)) layer 232 and a glass (for example, borophosphosilicate glass (BPSG)) layer 234. The stack 230 may further include additional insulating and/or barrier layers if needed. For example, a thin silicon nitride layer (not explicitly shown) may be provided between TEOS layer 232 and the upper surface 214 of the substrate 212.

With reference to the left side of Figure 9, a source metal contact 240 extends through the layers of the stack 230, positioned between the locations of adjacent trenches 218, to make electrical contact with the doped source region 226. Each source metal contact 240 extends depthwise into the substrate to pass through the doped source region 236 and partially into the doped body region 234 (thus providing a body contact for the transistor 210 that is tied to the source). A source metal layer 242 extends over both the stack 230 and the source metal contacts 240 to provide an electrical connection to and between all source metal contacts 240. The layers of the stack 230 insulate both the source metal layer 242 and the source metal contacts 240 from the polygate (second polysilicon region 222b).

With reference now to the right side of Figure 9, the gate metal contact 250 for each polygate extends through the layers of the stack 230, positioned in vertical alignment with the location of the trench 218 to make electrical contact with the bridge portion 323 in the region 302. Each gate metal contact 250 extends depthwise only partially into an upper part of the (thicker) bridge portion 323 at regions 302. A gate metal layer 248 extends over both the stack 230 and the gate metal contacts 250 to provide an electrical connection to and between all gate metal contacts 250. The layers of the stack 230 insulate both the gate metal layer 248 and the gate metal contacts 250 from the source metal contacts and source regions.

The process for formation of the gate contact 250 utilizes a mask with a mask opening aligned with the center of the trench 218 in region 302. An etch performed using this mask produces a gate opening extending through the stack 230 and partially into the bridge 323 of the second polysilicon region 222b which forms the polygate. That etch may include multiple, discrete, etch steps including a first etch to remove the layers of the stack 230 and a second etch to extend into the bridge 323 for a desired depth (taking advantage of the extra thickness available in region 302 for the bridge 323). The size of the mask opening, and the corresponding gate opening, is typically designed to be about, and more preferably less than, one-half the size (width) of the trench 218 and is generally speaking preferably aligned with the center of the trench. A barrier layer 292 formed of a Titanium-Titanium Nitride (Ti-TiN) material is then conformally deposited into the etched gate opening, and the gate opening is then filled with a plug 294 made of a conductive material (such as, for example, Tungsten) to form the gate contact 250. It will be noted that the gate opening for insertion of the gate contact 250 has a depth extending partially into the gate bridge 323 without reaching the polyoxide region 228 or the included void. The double ended arrow in Figure 10G-2 illustrates the safety offset distance that accrues in region 302 due to the extended depths of the recessed first polysilicon material 222a in regions 302 as compared to region 301. See, process steps shown in Figures 10B-2, 10C-2, 10D-2 and 10E-2.

It will be noted that because of the increased thickness of the bridge portion 323 in the region 302, there is a significantly reduced risk that etch of the contact opening to a depth extending partially into the bridge portion 323 will reach the polyoxide region 228b. Additionally, this etched opening will have a more uniform topology (compare to the nonuniform shape of the contact opening as shown by Figure 3C). As a result, the conformally deposited Ti-TiN barrier layer will completely cover this location and provide the necessary insulation presence and thickness. Furthermore, there is a corresponding reduced risk of the conductive material for the contact 250 that is deposited in the gate opening presenting a leakage path or short-circuit between the polygate and the polysource provided by the field plate. Additionally, because the contact 250 can be aligned with the center of the trench, as opposed to being offset from the center of the trench as in Figures 4 and 6, this architecture supports provision of a device with a reduced pitch.

The cross-sections on the left and right sides of Figure 9 are, in practice, actually longitudinally offset from each other in the direction perpendicular to the cross-section (i.e., into and out of the page of the illustration). In this configuration, an insulating separation is provided between the source metal layer 242 and the gate metal layer 248.

A drain metal layer 244 extends over the back side 216 of the substrate 212 to provide a metal connection to the drain.

The transistor 210 could instead be a pMOS type transistor where the substrate 212 and doped source region 226 are both p-type doped and the body region 224 is n-type doped.

Figure 11 is a plan view (i.e., looking downward towards the front surface of the substrate) illustrating the layout for the transistor 210 with a specific focus showing the relative locations of the contacts 240 and 250. The dashed line indicates the center line of each longitudinally extending trench. The dotted line 310 indicates the general location of the cross-section for the left side of Figure 9. The dotted line 312 indicated the general location of the cross-section shown for all of the Figures 10A-10G with a "-1" suffix which are related to region 301. The dotted line 314 indicates the general location of the cross-section for the right side of Figure 9 as well as the general location of the cross-section shown for all of the Figures 10A-10G with a "-2" suffix which are related to region 302.

For the discussion herein, it will be noted that the term "longitudinal" refers to a first direction for example extending along the length of the trench and the term "lateral" refers to a second direction for example extending along the width of the trench. The longitudinal and lateral directions are perpendicular to each other and extend parallel to an upper surface of the semiconductor substrate.

While the invention has been illustrated and described in detail in the drawings and foregoing description, such illustration and description are considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. 2). For reasons previously noted herein, this thermal oxidation process can in some cases produce voids in polyoxide regions 228a, 228b. It will be noted that the upper surfaces of the polyoxide regions 228a, 228b are recessed to different levels in the first and second regions 301, 302, respectively. The remaining lower portions of the first polysilicon material 222a form field plate electrodes of the transistor 210 (referred to also as the polysource regions because they are typically electrically shorted to the source regions 226 - this electrical connection is not explicitly shown in the figures). The side walls and bottom of the upper portion of each trench 218 are then lined with a second insulating layer 220b. For example, the insulating layer 220b may comprise a thermally grown oxide layer. The upper portion of each trench 218 is then filled by a second polysilicon material 222b, with the insulating layer 220b insulating the second polysilicon material 222b from the substrate 212 (including regions 224 and 226). See, Figures 10G-1 and 10G-2. The second polysilicon material 222b forms the gate (referred to as a polygate region) of the transistor 210 and includes a first (for example, left) gate lobe 321 and second (for example, right) gate lobe 322 which longitudinally extend in the trench on opposite sides of the polyoxide regions 228a, 228b. The first and second gate lobes are connected by a gate bridge portion 323 laterally extending over the polyoxide regions 228a, 228b. It will be noted that the vertical thicknesses of the bridge portions 323 are different in the regions 301 and 302. Specifically, the bridge portion 323 in region 302 where the transistor gate contact is going to be formed is thicker than the bridge portion 323 in region 301. The reason for, and advantage of, this will be apparent from the discussion below concerning the subsequent provision of the gate contact. It will also be noted that the first and second gate lobes 321, 322, extend to different depths in depths in the first and second regions 301, 302, respectively (the depth being greater in region 302 than in region 301). The insulating layer 220b forms the gate oxide layer.

A stack 230 of layers is formed above the upper surface of the substrate. The stack 230 includes an undoped oxide (for example, tetraethyl orthosilicate (TEOS)) layer 232 and a glass (for example, borophosphosilicate glass (BPSG)) layer 234. The stack 230 may further include additional insulating and/or barrier layers if needed. For example, a thin silicon nitride layer (not explicitly shown) may be provided between TEOS layer 232 and the upper surface 214 of the substrate 212.

With reference to the left side of Figure 9, a source metal contact 240 extends through the layers of the stack 230, positioned between the locations of adjacent trenches 218, to make electrical contact with the doped source region 226. Each source metal contact 240 extends depthwise into the substrate to pass through the doped source region 236 and partially into the doped body region 234 (thus providing a body contact for the transistor 210 that is tied to the source). A source metal layer 242 extends over both the stack 230 and the source metal contacts 240 to provide an electrical connection to and between all source metal contacts 240. The layers of the stack 230 insulate both the source metal layer 242 and the source metal contacts 240 from the polygate (second polysilicon region 222b).

With reference now to the right side of Figure 9, the gate metal contact 250 for each polygate extends through the layers of the stack 230, positioned in vertical alignment with the location of the trench 218 to make electrical contact with the bridge portion 323 in the region 302. Each gate metal contact 250 extends depthwise only partially into an upper part of the (thicker) bridge portion 323 at regions 302. A gate metal layer 248 extends over both the stack 230 and the gate metal contacts 250 to provide an electrical connection to and between all gate metal contacts 250. The layers of the stack 230 insulate both the gate metal layer 248 and the gate metal contacts 250 from the source metal contacts and source regions.

The process for formation of the gate contact 250 utilizes a mask with a mask opening aligned with the center of the trench 218 in region 302. An etch performed using this mask produces a gate opening extending through the stack 230 and partially into the bridge 323 of the second polysilicon region 222b which forms the polygate. That etch may include multiple, discrete, etch steps including a first etch to remove the layers of the stack 230 and a second etch to extend into the bridge 323 for a desired depth (taking advantage of the extra thickness available in region 302 for the bridge 323). The size of the mask opening, and the corresponding gate opening, is typically designed to be about, and more preferably less than, one-half the size (width) of the trench 218 and is generally speaking preferably aligned with the center of the trench. A barrier layer 292 formed of a Titanium-Titanium Nitride (Ti-TiN) material is then conformally deposited into the etched gate opening, and the gate opening is then filled with a plug 294 made of a conductive material (such as, for example, Tungsten) to form the gate contact 250. It will be noted that the gate opening for insertion of the gate contact 250 has a depth extending partially into the gate bridge 323 without reaching the polyoxide region 228 or the included void. The double ended arrow in Figure 10G-2 illustrates the safety offset distance that accrues in region 302 due to the extended depths of the recessed first polysilicon material 222a in regions 302 as compared to region 301. See, process steps shown in Figures 10B-2, 10C-2, 10D-2 and 10E-2.

It will be noted that because of the increased thickness of the bridge portion 323 in the region 302, there is a significantly reduced risk that etch of the contact opening to a depth extending partially into the bridge portion 323 will reach the polyoxide region 228b. Additionally, this etched opening will have a more uniform topology (compare to the nonuniform shape of the contact opening as shown by Figure 3C). As a result, the conformally deposited Ti-TiN barrier layer will completely cover this location and provide the necessary insulation presence and thickness. Furthermore, there is a corresponding reduced risk of the conductive material for the contact 250 that is deposited in the gate opening presenting a leakage path or short-circuit between the polygate and the polysource provided by the field plate. Additionally, because the contact 250 can be aligned with the center of the trench, as opposed to being offset from the center of the trench as in Figures 4 and 6, this architecture supports provision of a device with a reduced pitch.

The cross-sections on the left and right sides of Figure 9 are, in practice, actually longitudinally offset from each other in the direction perpendicular to the cross-section (i.e., into and out of the page of the illustration). In this configuration, an insulating separation is provided between the source metal layer 242 and the gate metal layer 248.

A drain metal layer 244 extends over the back side 216 of the substrate 212 to provide a metal connection to the drain.

The transistor 210 could instead be a pMOS type transistor where the substrate 212 and doped source region 226 are both p-type doped and the body region 224 is n-type doped.

Figure 11 is a plan view (i.e., looking downward towards the front surface of the substrate) illustrating the layout for the transistor 210 with a specific focus showing the relative locations of the contacts 240 and 250. The dashed line indicates the center line of each longitudinally extending trench. The dotted line 310 indicates the general location of the cross-section for the left side of Figure 9. The dotted line 312 indicated the general location of the cross-section shown for all of the Figures 10A-10G with a "-1" suffix which are related to region 301. The dotted line 314 indicates the general location of the cross-section for the right side of Figure 9 as well as the general location of the cross-section shown for all of the Figures 10A-10G with a "-2" suffix which are related to region 302.

For the discussion herein, it will be noted that the term "longitudinal" refers to a first direction for example extending along the length of the trench and the term "lateral" refers to a second direction for example extending along the width of the trench. The longitudinal and lateral directions are perpendicular to each other and extend parallel to an upper surface of the semiconductor substrate.

While the invention has been illustrated and described in detail in the drawings and foregoing description, such illustration and description are considered illustrative or exemplary and not restrictive; the invention is not limited to the disclosed embodiments but is solely defined by the appended claims.
Other variations to the disclosed embodiments can be understood and effected by those skilled in the art in practicing the claimed invention, from a study of the drawings, the disclosure, and the appended claims.

## Claims

1. A method for manufacturing a trench-gate filed effect transistor, comprising:
- using a semiconductor substrate (212) doped with a first conductivity type;
- implanting a first doped region that is doped with the first conductivity type at the upper surface of the semiconductor substrate;
burying a second doped region that is doped with a second conductivity type, that is opposite the first conductivity type, below the first doped region; and
forming a trench (218) in a semiconductor substrate (212), and wherein said trench (218) extends in depth completely through both of the first and second doped regions;
lining sidewalls and a bottom of the trench (218) with a first insulating layer (220A);
filling the trench (218) with a first polysilicon material (222);
forming a mask covering the trench (218) at a first region of the semiconductor substrate, said mask including a first opening over the trench (218) at a second region of the semiconductor substrate;
using said first opening, etching to selectively remove a first portion of the first polysilicon material (222) at said second region of the semiconductor substrate;
removing the mask;
etching to selectively remove a second portion of the first polysilicon material (222) at said first region of the semiconductor substrate (212) and selectively remove a third portion of the first polysilicon material (222) at said second region of the semiconductor substrate;
selectively remove or recess an upper portion of the first insulating layer (220A) in said trench (218) to a first depth at said first region of the semiconductor substrate (212) and to second depth at said second region of the semiconductor substrate (212) corresponding to a trench (218) to expose an upper portion of the first polysilicon material (222) in an upper portion of said trench, said second depth being greater that said first depth;
converting the exposed upper portion of the first polysilicon material (222) in said trench (218) to a oxidized polysilicon material (228);
lining sidewalls and a bottom of the upper portion of said trench (218) with a second insulating layer; and
filling the upper portion of said trench (218) with a second polysilicon material,
wherein the second region will be used to form gate contacts.

2. The method of claim 1, wherein a remaining portion of the first polysilicon material (222) in said trench (218) forms a transistor field plate electrode, and wherein the second polysilicon material (222B) forms a transistor gate electrode.

3. The method of claim 2, wherein the second polysilicon material (222B) that forms the transistor gate electrode includes a first gate lobe (321) on one side of the oxidized polysilicon material (228), a second gate lobe on an opposite side of the oxidized polysilicon material (228), and a gate bridge (323) extending over the oxidized polysilicon material (228).

4. The method of claim 3, further comprising:
forming a stack of insulating layers covering the transistor gate electrode, the trench (218) and the semiconductor substrate;
at said second region, forming a third opening aligned with the trench (218) and extending through the stack of insulating layer and partially extending into the gate bridge (323); and
forming a gate contact in said third opening.

5. The method of any of claims 1 to 4, wherein the semiconductor substrate (212) forms a transistor drain, the first doped region forms a transistor source and the second doped region forms a transistor body.

6. An integrated trench gate field effect transistor, comprising:
a semiconductor substrate (212) providing a drain;
a first doped region in the semiconductor substrate (212) providing a source;
a second doped region buried in the semiconductor substrate (212) below the first doped region and providing a body;
a trench extending into the semiconductor substrate (212) and passing through the first and second doped regions;
a oxidized polysilicon region within the trench (218); and
a polygate region within the trench (218), said polygate region comprising: a first gate lobe (321) on a first side of the oxidized polysilicon region, a second gate lobe (322) on a second side of the oxidized polysilicon region opposite said first side, and a gate bridge (323) extending over the oxidized polysilicon region;
a stack of insulating layers covering the transistor gate electrode, the trench (218) and the semiconductor substrate;
an opening at a second region aligned with the trench (218) and extending through the stack of insulating layer and partially extending into the gate bridge (323); and
a gate contact in said opening;
wherein, at a first region of the semiconductor substrate, the oxidized polysilicon region is recessed within the trench (218) to a first level and the first and second gate lobes (321, 322) extend to a first depth within the trench (218);
wherein, at said second region of the semiconductor substrate, the oxidized polysilicon region is recessed within the trench (218) to a second level and the first and second gate lobes (321, 322) extend to a second depth within the trench (218); and
wherein said second level is greater in depth than said first level the first and said second depth is greater than said first depth;
wherein, at said first region of the semiconductor substrate, the gate bridge (323) has a first thickness;
wherein, at said second region of the semiconductor substrate, the gate bridge (323) has a second thickness that is greater than the first thickness.

7. The integrated circuit transistor device of claim 6, further comprising a field plate shorted to the source within said trench (218), wherein the field plate shorted to the source is longitudinally aligned with the oxidized polysilicon region.

8. The integrated circuit transistor device of claim 7, wherein said oxidized polysilicon region is an oxidized portion of said field plate shorted to the source.

## Patentansprüche

1. Ein Verfahren zum Herstellen eines Trench-Gate-Feldeffekttransistors, das Folgendes aufweist:
- Verwenden eines Halbleitersubstrats (212), das mit einem ersten Leitfähigkeitstyp dotiert ist;
- Implantieren eines ersten dotierten Bereichs, der mit dem ersten Leitfähigkeitstyp dotiert ist, an der oberen Oberfläche des Halbleitersubstrats; Vergraben eines zweiten dotierten Bereichs, der mit einem zweiten Leitfähigkeitstyp dotiert ist, der dem ersten Leitfähigkeitstyp entgegengesetzt ist, unterhalb des ersten dotierten Bereichs; und
Ausbilden eines Grabens (218) in einem Halbleitersubstrat (212), wobei sich der genannte Graben (218) in der Tiefe vollständig durch sowohl den ersten als auch den zweiten dotierten Bereich erstreckt;
Auskleiden von Seitenwänden und eines Bodens des Grabens (218) mit einer ersten Isolierschicht (220A);
Füllen des Grabens (218) mit einem ersten Polysiliziummaterial (222); Ausbilden einer Maske, die den Graben (218) in einem ersten Bereich des Halbleitersubstrats bedeckt, wobei die genannte Maske eine erste Öffnung über dem Graben (218) in einem zweiten Bereich des Halbleitersubstrats aufweist;
unter Verwendung der genannten ersten Öffnung Ätzen zum selektiven Entfernen eines ersten Abschnitts des ersten Polysiliziummaterials (222) in dem genannten zweiten Bereich des Halbleitersubstrats;
Entfernen der Maske;
Ätzen zum selektiven Entfernen eines zweiten Abschnitts des ersten Polysiliziummaterials (222) in dem genannten ersten Bereich des Halbleitersubstrats (212) und zum selektiven Entfernen eines dritten Abschnitts des ersten Polysiliziummaterials (222) in dem genannten zweiten Bereich des Halbleitersubstrats;
selektives Entfernen oder Zurücksetzen eines oberen Abschnitts der ersten Isolierschicht (220A) in dem genannten Graben (218) bis zu einer ersten Tiefe in dem genannten ersten Bereich des Halbleitersubstrats (212) und bis zu einer zweiten Tiefe in dem genannten zweiten Bereich des Halbleitersubstrats (212), entsprechend einem Graben (218), um einen oberen Abschnitt des ersten Polysiliziummaterials (222) in einem oberen Abschnitt des genannten Grabens freizulegen, wobei die genannte zweite Tiefe größer als die genannte erste Tiefe ist;
Umwandeln des freigelegten oberen Abschnitts des ersten Polysiliziummaterials (222) in dem genannten Graben (218) in ein oxidiertes Polysiliziummaterial (228);
Auskleiden von Seitenwänden und eines Bodens des oberen Abschnitts des genannten Grabens (218) mit einer zweiten Isolierschicht; und
Füllen des oberen Abschnitts des genannten Grabens (218) mit einem zweiten Polysiliziummaterial, wobei der zweite Bereich zum Ausbilden von Gate-Kontakten verwendet wird.

2. Das Verfahren nach Anspruch 1, wobei ein verbleibender Abschnitt des ersten Polysiliziummaterials (222) in dem genannten Graben (218) eine Feldelektrode des Transistors bildet und wobei das zweite Polysiliziummaterial (222B) eine Gate-Elektrode des Transistors bildet.

3. Das Verfahren nach Anspruch 2, wobei das zweite Polysiliziummaterial (222B), das die Gate-Elektrode des Transistors bildet, einen ersten Gate-Lappen (321) auf einer Seite des oxidierten Polysiliziummaterials (228), einen zweiten Gate-Lappen auf einer gegenüberliegenden Seite des oxidierten Polysiliziummaterials (228) und eine Gate-Brücke (323), die sich über das oxidierte Polysiliziummaterial (228) erstreckt, aufweist.

4. Das Verfahren nach Anspruch 3, ferner aufweisend:
Ausbilden eines Stapels von Isolierschichten, der die Gate-Elektrode des Transistors, den Graben (218) und das Halbleitersubstrat bedeckt;
in dem genannten zweiten Bereich Ausbilden einer dritten Öffnung, die mit dem Graben (218) ausgerichtet ist und sich durch den Stapel von Isolierschichten erstreckt und sich teilweise in die Gate-Brücke (323) erstreckt; und Ausbilden eines Gate-Kontakts in der genannten dritten Öffnung.

5. Das Verfahren nach einem der Ansprüche 1 bis 4, wobei das Halbleitersubstrat (212) eine Transistorsenke bildet, der erste dotierte Bereich eine Transistorquelle bildet und der zweite dotierte Bereich einen Transistorkörper bildet.

6. Ein integrierter Trench-Gate-Feldeffekttransistor, der Folgendes aufweist:
ein Halbleitersubstrat (212), das eine Senke bereitstellt;
einen ersten dotierten Bereich in dem Halbleitersubstrat (212), der eine Quelle bereitstellt;
einen zweiten dotierten Bereich, der in dem Halbleitersubstrat (212) unterhalb des ersten dotierten Bereichs vergraben ist und einen Körper bereitstellt;
einen Graben, der sich in das Halbleitersubstrat (212) erstreckt und durch den ersten und den zweiten dotierten Bereich verläuft;
einen oxidierten Polysiliziumbereich innerhalb des Grabens (218); und
einen Polygate-Bereich innerhalb des Grabens (218), wobei der genannte Polygate-Bereich Folgendes aufweist: einen ersten Gate-Lappen (321) auf einer ersten Seite des oxidierten Polysiliziumbereichs, einen zweiten Gate-Lappen (322) auf einer zweiten Seite des oxidierten Polysiliziumbereichs gegenüber der genannten ersten Seite und eine Gate-Brücke (323), die sich über den oxidierten Polysiliziumbereich erstreckt;
einen Stapel von Isolierschichten, der die Gate-Elektrode des Transistors, den Graben (218) und das Halbleitersubstrat bedeckt;
eine Öffnung in einem zweiten Bereich, die mit dem Graben (218) ausgerichtet ist und sich durch den Stapel von Isolierschichten erstreckt und sich teilweise in die Gate-Brücke (323) erstreckt; und einen Gate-Kontakt in der genannten Öffnung;
wobei in einem ersten Bereich des Halbleitersubstrats der oxidierte Polysiliziumbereich innerhalb des Grabens (218) bis zu einer ersten Stufe zurückgesetzt ist und sich der erste und der zweite Gate-Lappen (321, 322) bis zu einer ersten Tiefe innerhalb des Grabens (218) erstrecken;
wobei in dem genannten zweiten Bereich des Halbleitersubstrats der oxidierte Polysiliziumbereich innerhalb des Grabens (218) bis zu einer zweiten Stufe zurückgesetzt ist und sich der erste und der zweite Gate-Lappen (321, 322) bis zu einer zweiten Tiefe innerhalb des Grabens (218) erstrecken; und
wobei die genannte zweite Stufe in der Tiefe größer als die genannte erste Stufe der erste und die genannte zweite Tiefe größer als die genannte erste Tiefe ist
wobei in dem genannten ersten Bereich des Halbleitersubstrats die Gate-Brücke (323) eine erste Dicke aufweist;
wobei in dem genannten zweiten Bereich des Halbleitersubstrats die Gate-Brücke (323) eine zweite Dicke aufweist, die größer als die erste Dicke ist.

7. Die integrierte Schaltungstransistoreinrichtung nach Anspruch 6, ferner eine Feldelektrode aufweisend, die innerhalb des genannten Grabens (218) mit der Quelle kurzgeschlossen ist, wobei die mit der Quelle kurzgeschlossene Feldelektrode in Längsrichtung mit dem oxidierten Polysiliziumbereich ausgerichtet ist.

8. Die integrierte Schaltungstransistoreinrichtung nach Anspruch 7, wobei der genannte oxidierte Polysiliziumbereich ein oxidierter Abschnitt der genannten mit der Quelle kurzgeschlossenen Feldelektrode ist.

## Revendications

1. Procédé de fabrication d'un transistor à effet de champ à grille en tranchée, comprenant :
- l'utilisation d'un substrat semiconducteur (212) dopé d'un premier type de conductivité ;
- l'implantation d'une première région dopée du premier type de conductivité à la surface supérieure du substrat semiconducteur ;
l'enfouissement d'une deuxième région dopée, dopée d'un deuxième type de conductivité, opposé au premier type de conductivité, sous la première région dopée ; et
la formation d'une tranchée (218) dans un substrat semiconducteur (212), et dans lequel ladite tranchée (218) s'étend en profondeur complétement à travers les première et deuxième régions dopées à la fois ;
le revêtement de parois latérales et d'un fond de la tranchée (218) avec une première couche isolante (220A) ;
le remplissage de la tranchée (218) avec un premier matériau en silicium polycristallin (222) ;
la formation d'un masque recouvrant la tranchée (218) au niveau d'une première région du substrat semiconducteur, ledit masque comportant une première ouverture au-dessus de la tranchée (218) au niveau d'une deuxième région du substrat semiconducteur ;
en utilisant ladite première ouverture, la gravure pour enlever sélectivement une première partie du premier matériau en silicium polycristallin (222) au niveau de ladite deuxième région du substrat semiconducteur ;
le retrait du masque ;
la gravure pour retirer sélectivement une deuxième partie du premier matériau en silicium polycristallin (222) au niveau de ladite première région du substrat semiconducteur (212) et retirer sélectivement une troisième partie du premier matériau en silicium polycristallin (222) au niveau de ladite deuxième région du substrat semiconducteur ;
le retrait ou le creusement sélectif d'une partie supérieure de la première couche isolante (220A) dans ladite tranchée (218) jusqu'à une première profondeur au niveau de ladite première région du substrat semiconducteur (212) et jusqu'à une deuxième profondeur au niveau de ladite deuxième région du substrat semiconducteur (212) correspondant à une tranchée (218) pour exposer une partie supérieure du premier matériau en silicium polycristallin (222) dans une partie supérieure de ladite tranchée, ladite deuxième profondeur étant supérieure à ladite première profondeur ;
la conversion de la partie supérieure exposée du premier matériau en silicium polycristallin (222) dans ladite tranchée (218) en un matériau en silicium polycristallin oxydé (228) ;
le revêtement de parois latérales et d'un fond de la partie supérieure de ladite tranchée (218) avec une deuxième couche isolante ; et
le remplissage de la partie supérieure de ladite tranchée (218) avec un deuxième matériau en silicium polycristallin, dans lequel la deuxième région sera utilisée pour former des contacts de grille.

2. Procédé selon la revendication 1, dans lequel une partie restante du premier matériau en silicium polycristallin (222) dans ladite tranchée (218) forme une électrode de plaque de champ de transistor, et dans lequel le deuxième matériau en silicium polycristallin (222B) forme une électrode de grille de transistor.

3. Procédé selon la revendication 2, dans lequel le deuxième matériau en silicium polycristallin (222B) qui forme l'électrode de grille du transistor comporte un premier lobe de grille (321) sur un côté du matériau en silicium polycristallin oxydé (228), un deuxième lobe de grille sur un côté opposé du matériau en silicium polycristallin oxydé (228) et un pont de grille (323) s'étendant sur le matériau en silicium polycristallin oxydé (228).

4. Procédé selon la revendication 3, comprenant en outre :
la formation d'un empilement de couches isolantes recouvrant l'électrode de grille du transistor, la tranchée (218) et le substrat semiconducteur ;
au niveau de ladite deuxième région, la formation d'une troisième ouverture alignée avec la tranchée (218) et traversant l'empilement de couches isolantes et s'étendant partiellement à l'intérieur du pont de grille (323) ; et
la formation d'un contact de grille dans ladite troisième ouverture.

5. Procédé selon l'une quelconque des revendications 1 à 4, dans lequel le substrat semiconducteur (212) constitue un drain de transistor, la première région dopée constitue une source de transistor et la deuxième région dopée constitue un corps de transistor.

6. Transistor à effet de champ à grille en tranchée intégré, comprenant :
un substrat semiconducteur (212) servant de drain ;
une première région dopée dans le substrat semiconducteur (212) servant de source ;
une deuxième région dopée enfouie dans le substrat semiconducteur (212) sous la première région dopée et servant de corps ;
une tranchée s'étendant dans le substrat semiconducteur (212) et traversant les première et deuxième régions dopées ;
une région en silicium polycristallin oxydé à l'intérieur de la tranchée (218) ; et
une région de grille en silicium polycristallin à l'intérieur de la tranchée (218), ladite région de grille en silicium polycristallin comprenant : un premier lobe de grille (321) sur un côté de la région en silicium polycristallin oxydé, un deuxième lobe de grille (322) sur un deuxième côté (218) de la région en silicium polycristallin oxydé opposé audit premier côté et un pont de grille (323) s'étendant sur la région en silicium polycristallin oxydé ;
un empilement de couches isolantes recouvrant l'électrode de grille du transistor, la tranchée (218) et le substrat semiconducteur ;
une ouverture au niveau d'une deuxième région, alignée avec la tranchée (218) et traversant l'empilement de couches isolantes et s'étendant partiellement à l'intérieur du pont de grille (323) ; et
un contact de grille dans ladite ouverture ;
dans lequel, au niveau d'une première région du substrat semiconducteur, la région en silicium polycristallin oxydé est encastrée à l'intérieur de la tranchée (218) jusqu'à un premier niveau et les premier et deuxième lobes de grille (321, 322) s'étendent jusqu'à une première profondeur à l'intérieur de la tranchée (218) ;
dans lequel, au niveau de ladite deuxième région du substrat semiconducteur, la région en silicium polycristallin oxydé est encastrée à l'intérieur de la tranchée (218) jusqu'à un deuxième niveau et les premier et deuxième lobes de grille (321, 322) s'étendent jusqu'à une deuxième profondeur à l'intérieur de la tranchée (218) ; et
dans lequel ledit deuxième niveau est plus profond que ledit premier niveau, et ladite deuxième profondeur est supérieure à ladite première profondeur ;
dans lequel, au niveau de ladite première région du substrat semiconducteur, le pont de grille (323) a une première épaisseur ;
dans lequel, au niveau de ladite deuxième région du substrat semiconducteur, le pont de grille (323) a une deuxième épaisseur supérieure à la première épaisseur.

7. Dispositif transistor en circuit intégré selon la revendication 6, comprenant en outre une plaque de champ court-circuitée à la source à l'intérieur de ladite tranchée (218), dans lequel la plaque de champ court-circuitée à la source est alignée longitudinalement avec la région en silicium polycristallin oxydé.

8. Dispositif transistor en circuit intégré selon la revendication 7, dans lequel ladite région en silicium polycristallin oxydé est une partie oxydée de ladite plaque de champ court-circuitée à la source.
